# EUROPEAN PATENT APPLICATION

(11) **EP 4 607 787 A1**
(43) Date of publication of application: **27.08.2025**
(21) Application number: 25158653.3
(22) Date of filing: 18.02.2025
(51) Int. Cl.: H02S 10/10, H02S 40/44, H10N 10/00

(54) **INTEGRATED SYSTEM FOR INCREASING THE EFFICIENCY OF A PHOTOVOLTAIC PANEL FOR THE PRODUCTION OF ELECTRICITY**

(30) Priority: 22.02.2024 IT 202400003745
(71) Applicant: Russo, Carlo, 50018 Scandicci (FI) (IT)
(72) Inventor: Russo, Carlo, 50018 Scandicci (FI) (IT)
(74) Representative: Fiammenghi, Eva

(57) **Abstract**

System (1) for increasing the energy efficiency of photovoltaic panels (2), in which an integrative panel (3) for increasing the energy efficiency is coupled in the system (1) to a photovoltaic panel (2), where the integrative panel (3) is composed of a material transparent to sunlight and has an upper surface turned towards the sunlight source and a lower surface turned towards the photovoltaic panel (2), in a manner such that the space, called microclimate (11), formed between integrative panel (3) and photovoltaic panel (2) is heated due to the effect of light and heat trapped inside it. The system (1) also comprises:
- thermoelectric transducers (5) integrated in the integrative panel (3), to transform the heat of the microclimate (11) into electrical current (Ip),
- means (6) for collecting such heat conversion electrical current (Ip) and conveying it to an current adder (7), and
- means (8) for collecting a photovoltaic electrical current (Ib) from the photovoltaic panel (2) and conveying it towards said current adder (7),
- the current adder (7), by adding the photovoltaic current (Ib) to the heat conversion current (Ip), for increasing the efficiency of the system (1) with respect to that of the photovoltaic panel (2) alone with the same intensity of incident solar radiation.

## Description

### Field of the art

The present invention generally regards the photovoltaic industry and in particular an integrative system for increasing the efficiency of a photovoltaic panel for producing electrical energy. The integrative system of the present invention can be applied to photovoltaic panels mounted in any place, e.g. on roofs of buildings, in photovoltaic plants distributed on lots of terrain, on the ground, on electric vehicles or elsewhere.

### Prior art

In the prior art of the field, one of the main objects has been that of obtaining high efficiency in the transformation of solar energy into electrical energy. One such system, termed "High Efficiency Panels", comprises multiple devices:
- Photovoltaic cells formed by very high quality semiconductor material, i.e. ultra-pure monocrystalline silicon with a low rate of degradation over time;
- Very low dispersion electrical contacts in order to pick up the electrical current generated by the silicon cells;
- Photovoltaic cells produced with highly solid mechanical characteristics capable of further reducing the degradation of the cells themselves over time.

The efficiency of these known systems does not exceed 30%.

A disadvantage of this first system of known type is given by the fact that the performance (i.e. the efficiency) of the photovoltaic panel is linked to the very high quality of the raw materials, and this leads to high raw material purchasing costs.

A further disadvantage is given by the fact that the complexity of the requested production cycle is high, which involves another production cost and high energy consumptions in producing the panels.

A further disadvantage is given by the fact that even if the complexity of the known system is considerable, the efficiency obtained is still not greater than 30%, considering that in general a perfect efficiency must approach 100%.

Therefore, a first object of the present invention is to obtain an increase of the performance i.e. of the efficiency of the photovoltaic panels currently present on the market, i.e. a greater supply of electrical energy with the same solar energy incident on the panel, up to reaching an efficiency as close as possible to the ideal 100%.

A second object of the present invention is to provide a system that can be integrated with the pre-existing panels, without having to change them, improving the efficiency thereof.

A further object of the present invention is possibly the reduction of the production costs and/or raw material costs.

### Description of the invention

The present invention obtains its objects by means of an integrative system for increasing the efficiency of a photovoltaic panel for producing electrical energy, as defined in the independent claim 1.

The dependent claims regard improvement characteristics of the invention, which enhance the advantages thereof.

The concept underlying the present invention consists of creating an integrative system for increasing the efficiency of a photovoltaic panel, such system comprising, in addition to a common photovoltaic panel, one or more panels made of material transparent to sunlight, joined together along the edges so as to form an integrative panel for increasing efficiency (abbreviated in PIIR), which increases the energy efficiency of the common photovoltaic panel. The integrative panel comprises said one or more panels made of material that is transparent to sunlight, which in turn are constituted by at least a layer of transparent material. Each panel transparent to sunlight is also termed PIIR module, or module of the integrative panel for increasing the efficiency. A PIIR panel is therefore composed of one or more PIIR modules, each of which formed by one or more superimposed layers of material transparent to sunlight, e.g. glass, plexiglass or other.

The **PIIR** panel is superimposed and coupled to the common photovoltaic panel; in addition, the plane defined by the **PIIR** panel preferably is extended substantially parallel to the plane defined by the photovoltaic panel.

The two panels, the photovoltaic and the **PIIR** panel, are spaced from each other, i.e. they are not directly in contact with each other; however, these can be physically connected by means of connection walls. For example, such connection walls can be substantially orthogonal to the planes defined by two panels, i.e. by the photovoltaic panel and by the **PIIR** integrative panel. Altogether, one obtains in this case a box-like structure that encloses a space termed "microclimate" space. In this microclimate, a greenhouse effect is created during the irradiation with the solar rays. Therefore, the application of the **PIIR** integrative panel on the existing photovoltaic panel allows creating a microclimate, and in this microclimate, due to the characteristic of transparency of the material of the PIIR integrative panel, a temperature increase occurs, due to the greenhouse effect in the same microclimate.

The integrative system for increasing the efficiency of a photovoltaic panel, according to the present invention, also comprises means for transforming the heat formed by the greenhouse effect into electrical current. Said heat is then collected by at least a thermoelectric transducer, which transforms the heat in the space of the microclimate into electrical energy, according to the known Seebeck effect. Such electrical energy is summed according to the invention to the current normally generated by the photovoltaic panel.

According to the present invention, means are then provided for collecting the electrical current obtained from the heat and means are provided for summing the electrical current obtained from the heat with the photovoltaic current normally obtained from the photovoltaic cells that compose the various modules of the common photovoltaic panel.

The total current produced is thus composed of the base current Ib coming from the photovoltaic panel and of the current Ip obtained from one or more thermoelectric transducers, which are coupled or integrated in the transparent material that composes said one or more layers of the **PIIR** panel. Said transducers or thermoelectric sensors can be miniaturized and integrated in the various **PIIR** modules of the **PIIR** integrative panel.

The sum of the currents Ip and Ib is obtained by a so-called current adder PIIR.

It should be observed that said transducers, also termed thermocouples or thermoelectric sensors, are passive elements, i.e. they don't require power supply.

The use of various **PIIR** modules, assembled together along the sides/edges, for forming the **PIIR** integrative panel to be superimposed on the common photovoltaic panel, has the advantage that the modularity allows creating **PIIR** panels with dimensions adaptable to various needs and in particular to the dimensions of the photovoltaic panels. This can also be advantageous with regard to the logistics aspect (transport and storage) and/or with regard to production.

Preferably, the integrative system for increasing the efficiency of a photovoltaic panel, or **PIIR** system according to the present invention, comprising the integrative panel for increasing efficiency or **PIIR** panel and the commune photovoltaic panel, it is also provided with mirrors of limited size or micro-mirrors. Such mirrors or micro-mirrors are applied on part of the lower surface of the **PIIR** panel, where with the term "lower surface" it is intended the surface of the **PIIR** panel turned towards the photovoltaic panel in the installation condition. The "upper surface" of the **PIIR** panel is that which instead is turned towards the incident solar rays, during operation, and is turned in the opposite direction with respect to the photovoltaic panel.

Said mirrors are preferably designed with geometric characteristics such to produce the maximum reflection of the sunlight between the single photovoltaic cells of the photovoltaic panel and said one or more **PIIR** modules. Thus, in the zone/space of the microclimate, there are multiple reflections of the solar rays, which increase the heat due to the greenhouse effect and uniformly distribute it as well such to not create peaks of excessive heat in point-like zones of the two panels. This allows trapping, in addition to the heat, also the sunlight, forming a sort of "solar wave guide". The multiple reflections therefore also contribute to increasing the efficiency of the photovoltaic panel. There is therefore a double effect of the efficiency due to the introduction of the mirrors.

### Brief description of the drawings

The present invention will now be described as a non-limiting and non-binding example, according to several currently preferred embodiments thereof, with particular reference to the figures of the enclosed drawings, in which:
- Figure 1 schematically shows the operating principle of the integrative system for increasing the efficiency of a photovoltaic panel, according to the present invention;
- Figure 2 schematically shows the structure and how the PIIR modules made of transparent material are obtained (Figure 2 shows, both on the left and right, only one PIIR module, respectively);
- Figure 3 shows the application of an PIIR integrative panel to a common photovoltaic panel, for creating the microclimate with greenhouse effect.

### Detailed description of the invention

The following description does not enter into the construction details of photovoltaic panels, since these are known of course to the man skilled in the art. The latter, also for the attainment of the present invention, can use the materials and the devices/components that are known in the field, without any restrictions, so as long are such materials and devices are not clearly incompatible with the present finding and its inventive concept.

The following description does not delve into the technical details but it does expound on the technical information that will allow the man skilled in the art of the field to understand and attain the invention.

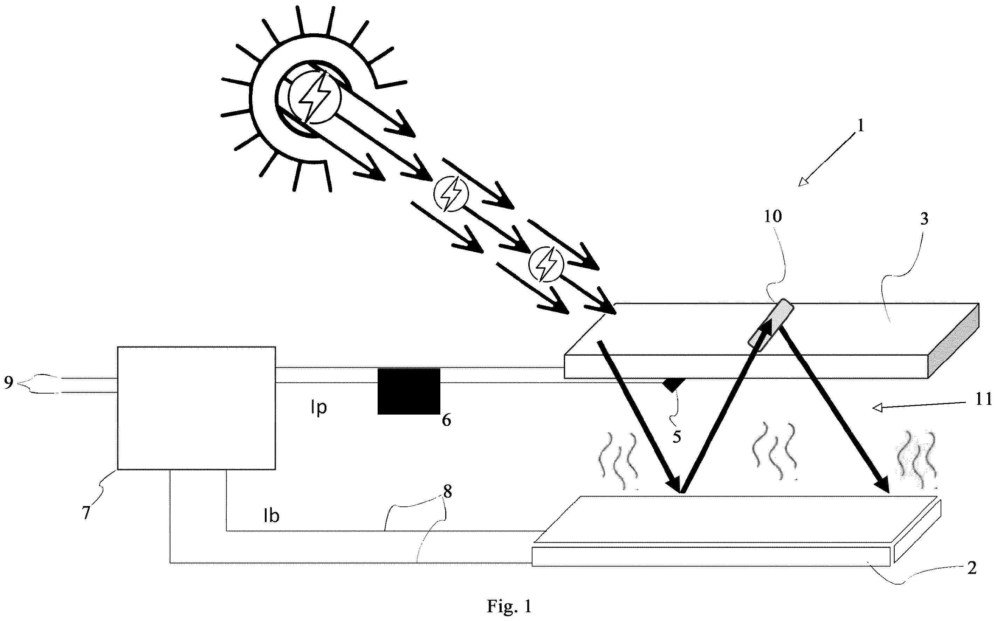

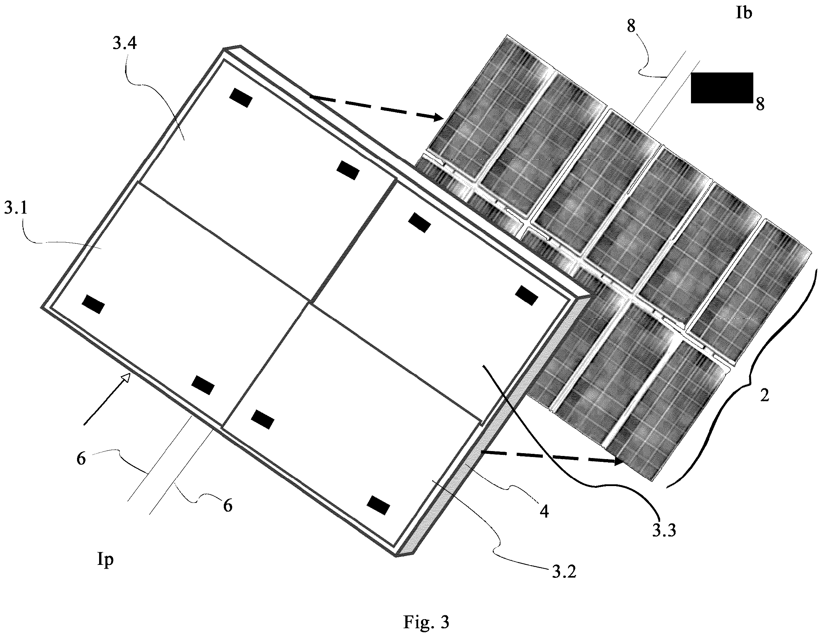

Figures 1 to 3 show the integrative system (PIIR) 1 for increasing the performance, i.e. the efficiency, of a photovoltaic panel 2 for transforming solar energy into electrical energy. Such system 1 comprises one or more modules/panels of material transparent to sunlight, also termed PIIR modules, indicated in Fig. 3 with reference numbers 3.1, 3.2, 3.3, 3.4 and overall indicated by reference number 3 in Fig. 1, where the reference number 3 indicates the PIIR panel, i.e. the integrative panel for increasing the efficiency. In this particular embodiment, said PIIR modules 3.1, 3.2, 3.3, 3.4 are four in number and have the same size. Of course this facilitates the production but the number and size of said PIIR modules could be variable, where, for example, the modules 3.1 and 3.4 could form only one rectangular module with double area, and so forth. Preferably, the photovoltaic panel 2 and the PIIR panel 3 will be geometrically congruent so as to create a perfect superimposition.

In this particular embodiment, a grid 4 is provided for the composition of the PIIR panel 3, and the various modules 3.1 - 3.4 are perfectly inserted into the grid 4 and can be snap fixed and/or glued, or blocked or joined by using other known assembly systems.

The integrative system 1 also provides for transducers 5 for transforming the heat into electrical energy, also termed PIIR microthermoelectric sensors. Also provided for is a system of electrical contacts and electrical conductors, overall indicated by the reference number 6 in Fig. 3, which are extended up to a PIIR current adder 7 (Fig. 1), transporting the current Ip generated by the various transducers 5 integrated in the PIIR modules 3.1 - 3.4 of the PIIR integrative panel 3. Other contacts and conductors 8 are provided (Fig. 1 and 3) for the photovoltaic panel 2, in the known manner, for collecting the current Ib (here termed base current), produced in the photovoltaic cells of the photovoltaic panel 2 and for conducting it to the PIIR current adder 7. The PIIR adder 7 then provides the total output current Itot on the output conductors 9 (Fig. 1).

Preferably, an assembly of mirrors or micromirrors 10; 10.1, 10.2 is integrated in the PIIR integrative panel 3, or better yet in said one or more PIIR modules 3.1 - 3.4 of the latter.

Illustrated in Fig. 1 is the effect produced by one of such mirrors which is indicated here with the reference number 10. Of course, the tilt of such mirror 10 is shown merely as an example, together with its shape and size, as well as its arrangement with respect to the body of the PIIR panel 3.

The PIIR panel 3 formed by the composition of the single PIIR modules 3.1-3.4, integrated with each other by suitable grid 4 and/or by casting of the same modules, or with another system, allows creating a space empty of air or other gas, between the surface of the photovoltaic panel 2 (composed of silicon photovoltaic cells) and the PIIR panel 3 itself. Such empty space 11 (Fig. 1) is the "microclimate" of the system PIIR 1 of the present invention.

As is seen in Fig. 1, the light emitted by the sun is refracted by the PIIR panel 3 and enters into the microclimate 11, hitting a silicon cell of the photovoltaic panel 2.

Due to the classic principles of thermodynamics and energy reflection, the solar energy is:
- for a part thereof, transmitted to (and absorbed by) the silicon photovoltaic cell, generating an electrical current, termed base current Ib, which is not lower than that normally generated without application of the PIIR integrative panel 3;
- for a part thereof transformed into heat, in which such heat due to the PIIR panel 3 remains trapped in the microclimate PIIR due to the known greenhouse effect;
- finally, for a part thereof it is reflected by the photovoltaic panel 2 in the form of optical energy, i.e. light.

The presence of the micromirrors 10; 10.1, 10.2 ensures multiple reflections as is clear in Fig. 1 and hence it enhances the preceding effects since the microclimate is heated even more; the sunlight can hit different points (on the photovoltaic cells) of the photovoltaic panel 2, creating a true "solar wave guide".

Therefore, in fact, the PIIR panel 3 creates a true greenhouse, at whose interior said microclimate 11 is developed. The heat generated in said microclimate 11 (Fig. 1, wavy lines) is captured by said transducers or microthermoelectric sensors 5 which generate electrical current Ip, which is added to the electrical current Ib generated by the silicon cells of the base photovoltaic panel 2. The sum of these two currents is carried out by an assembly of metal electrical contacts which forms the PIIR current adder assembly (block 7, Fig. 1). The base current Ib generated by the silicon photovoltaic cells can be greater than that normally generated without PIIR integrative panel 3, due to the application of the micromirrors 10; 10.1, 10.2 that capture the light in the microclimate PIIR 11, generating a multiple reflection that hits the single photovoltaic cell.

Hence, the total current Itot obtained by the integrated system - base panel (Ib) + PIIR panel (Ip) - is the generated useful current, greater than the electrical current generated in the absence of the PIIR integrative panel 3.

It follows that with the same solar energy, a greater electrical current produced by the integrative system of the invention (Panel base 2 + PIIR panel 3) increases the energy efficiency, i.e. it increases the efficiency of the solar conversion system.

In addition, it is necessary to underline that a photovoltaic panel 2 reduces its efficiency with wear over time; hence, by applying a PIIR panel 3 to a photovoltaic panel 2 that has been degraded over time, it is possible to restore its efficiency levels, actually extending the useful lifetime of the photovoltaic panel 2 itself.

The superimposition and the fixing of the PIIR panel 3 is ensured by a suitable design of a grid for fixing and composition of the PIIR panel and by relative mechanical fixing elements that have been suitably designed. Hence, the same grid of composition 4 mentioned above can simultaneously act as a connection element (or connection walls) with the photovoltaic panel 2.

It should be observed that the microclimate 11 can be completely closed in a watertight manner or, on the contrary, also be more or less open towards the external environment, this depending on the particular design and application, on the external climate conditions and on the ventilation, on the distance between the panels 2 and 3, on the fact that if the gas in the microclimate is air or another gas that must not be dispersed externally, or if in the microclimate 11 one prefers to generate a depression (negative pressure).

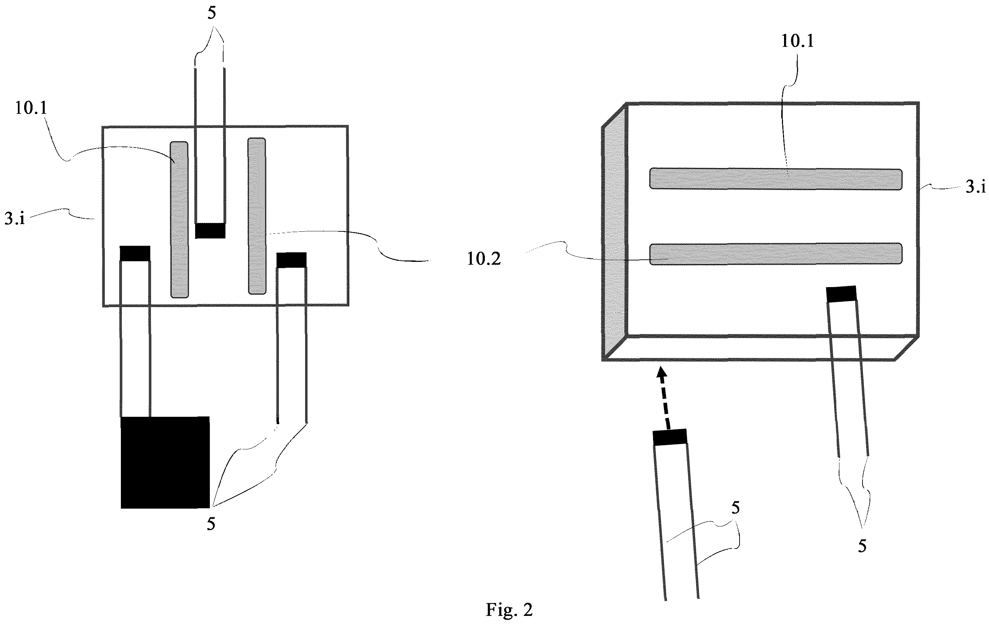

All this depends on the selection of the designers and on the particular technical application. The present invention has up to now been described with reference to a only one panel 2 / PIIR panel 3 pair. Of course, a photovoltaic plant can certainly comprise various photovoltaic panels 2 that are not necessarily spatially separated, but rather could be side-by-side each other. The present invention is of course also extended to this type of side-by-side photovoltaic panel plant. In this case, a plurality of PIIR panels 3 will be employed, preferably side-by-side /joined together and such to geometrically hit preferably the entire surface area formed by all the photovoltaic panels 2 side-by-side /joined together and constituting part of the plant. Finally, Fig. 2 schematically shows on the left a PIIR module 3.i in a plan view, on the right a PIIR module 3.i in a perspective view. By "lower surface" of the PIIR module it is always intended in the present context that surface which is turned towards the photovoltaic panel 2 in the installation condition, and by "upper surface" of the PIIR module it is always intended in the present context its surface turned towards the solar rays in the installation and operating condition.

On the right and left in Fig. 2, a PIIR module 3.i made of transparent material is shown, in which the mirrors 10.i (i = 1, 2) have a strip-like linear configuration and the microthermoelectric sensors PIIR 5 are integrated in said lower surface of the PIIR module 3.i. It is observed that the mutual arrangement and orientation between the components 10.i and 5 can vary depending on the design, the mutual orientation for example can be orthogonal (Fig. 2, to the right) or parallel (Fig. 2, to the left).

In summary, hereinbelow are the advantages of the present invention.

A first advantage is given by the fact that one obtains an improvement of the performance, i.e. of the efficiency, of a system of photovoltaic panels without having to change the existing photovoltaic panels.

A further advantage is given by the fact that the lifetime of an existing photovoltaic panel is extended.

A further advantage is given by the fact that the PIIR system of the invention can obtain high efficiencies even with limited production costs for the photovoltaic panel, since its operating principle is based on not dispersing the solar energy that hits the surface of the photovoltaic panel and not on the quality of the materials that compose the photovoltaic panel itself.

In addition, the use of nanotechnology materials transparent to sunlight, applicable to the surface of the PIIR modules or of specific gases in the PIIR microclimate 11, can increase both the incidence of the heat captured due to the greenhouse effect and the incidence of the solar light energy trapped in the same PIIR microclimate 11, i.e. increasing both the greenhouse effect and the solar wave guide effect.

In conclusion, it is evident that the present invention, if desired possibly reaching the object of increasing the efficiency of the system to a maximum but without particular attention to the production costs and raw material costs, could benefit from high performance photovoltaic panels, of already known type. Hence, with "photovoltaic panel" in the present context, it can be intended a conventional panel of any type, also high performance in terms of efficiency, already known. This depends on the designer, who can modulate among the various objects of the invention, selecting a solution that best fits the specific application. This is the significance of the following claim 14.

The present invention was described as a non-limiting example based on several embodiments and embodiment variants that are presently considered preferred, but it is intended that variations and/or modifications can be made by those skilled in the art without any inventive effort and without departing from the respective protective scope that is justly due to the invention, as defined in the enclosed claims.

### List of the reference numbers of the Figures

- 1: integrative system for increasing the energy efficiency
- 2: photovoltaic panel
- 3: integrative panel for increasing the efficiency (PIIR)
- 3.1 - 3.4: PIIR modules (in general 3.i: i = 1,...,N)
- 4: grid for composition and fixing of the PIIR modules
- 5: transducers, thermoelectric sensors
- 6: electrical conductors of the current Ip generated by 5
- 7: current adder
- 8: electrical conductors of the (base) photovoltaic current Ib
- 9: conductors of the total current Itot
- 10: mirrors, or micro-mirrors 10.1, 10.2 (in general 10.i: i = 1, ..., n)
- 11: microclimate, zone between components 2 and 3

## Claims

1. System (1) for increasing the energy efficiency of photovoltaic panels (2), **characterized in that** at least an integrative panel (3) for increasing the energy performance is coupled in the system (1) to at least one photovoltaic panel (2), where said at least one integrative panel (3) is composed of a material transparent to sunlight and has an upper surface which in the installation and operating condition of the system (1) is turned towards the source of sunlight and a lower surface which in the installation and operating condition is directed towards said at least one photovoltaic panel (2), so that the space, called microclimate (11), formed between said at least one integrative panel (3) and said at least one photovoltaic panel (2) is heated due to the effect of sunlight and the heat trapped inside it; said system (1) being further **characterized in that** it comprises:
- means (5) for energy conversion from heat to electrical energy, comprising thermoelectric transducers (5) integrated in said at least one integrative panel (3), to transform the heat of the microclimate (11) into electrical current (Ip),
- means (6) for collecting this heat conversion electric current (Ip) and conveying it to a current adder (7),
- means (8) for collecting a photovoltaic electric current (Ib) from said at least one photovoltaic panel (2) and conveying it towards said current adder (7),
and in which,
said current adder (7) adds the photovoltaic current (Ib) to the heat conversion current (Ip), to increase the energy efficiency of the system (1) compared to that of the photovoltaic panel(s) alone (2) at equal intensity of incident solar radiation.

2. System (1) for increasing the energy efficiency of photovoltaic panels (2) according to claim 1, **characterized in that** micromirrors (10.1, 10.2) are applied on part of said lower surface of said at least one integrative panel (3) to generate multiple reflections on said at least one photovoltaic panel (2), so as to increase the energy performance of said at least one photovoltaic panel (2), as well as increasing the heat captured and making the microclimate (11) act as a sort of solar wave guide.

3. System (1) for increasing the energy efficiency of photovoltaic panels (2) according to claim 1 or 2, **characterized in that** said at least one integrative panel (3) is composed of multiple modules (3.1, ..., 3.N) assembled along the edges in a permanent or removable way.

4. System (1) for increasing the energy efficiency of photovoltaic panels (2) according to any of the preceding claims, **characterized in that** said at least one integrative panel (3) or respectively said modules (3.1, ..., 3.N) is /are made up of various overlapping layers of materials transparent to sunlight.

5. System (1) for increasing the energy efficiency of photovoltaic panels (2) according to any of the preceding claims, **characterized in that** said modules (3.1, ....,3.N) are arranged within a grid (4) of composition of the integrative panel (3) and/or fixing it to said at least one photovoltaic panel (2).

6. System (1) for increasing the energy efficiency of photovoltaic panels (2) according to any of the preceding claims, **characterized in that** the space defined by the microclimate (11) is closed in a watertight manner.

7. System (1) for increasing the energy efficiency of photovoltaic panels (2) according to any of the preceding claims except for claim 6, **characterized in that** the space defined by the microclimate (11) is at least partly communicating with the external environment.

8. System (1) for increasing the energy efficiency of photovoltaic panels (2) according to claim 6, **characterized in that** a gas is introduced into the microclimate (11) which amplifies the efficiency of the heat captured due to the greenhouse effect.

9. System (1) for increasing the energy efficiency of photovoltaic panels (2) according to any of the preceding claims, **characterized in that** on at least one of the internal and/or external surfaces of said at least one integrative panel (3), or respectively of said modules (3.1 - 3.N) of the same, a transparent nanotechnology material is applied, to increase the efficiency of the heat captured by the greenhouse effect.

10. System (1) for increasing the energy efficiency of photovoltaic panels (2) according to any of the preceding claims, **characterized in that** said micromirrors (10.1, 10.2) are strip-shaped and are oriented in a parallel or orthogonal manner with respect to said thermoelectric transducers (5), or in another way, and are arranged in an alternating manner with respect to the thermoelectric transducers (5), or in another way.

11. System (1) for increasing the energy efficiency of photovoltaic panels (2) according to any of the preceding claims, **characterized in that** said at least one integrative panel (3) defines a geometric plane which is substantially parallel to a geometric plane defined by said at least one photovoltaic panel (2).

12. System (1) for increasing the energy efficiency of photovoltaic panels (2) according to claim 6, **characterized in that** a depression is generated in the microclimate (11), in order to adapt the system (1) to technical applications.

13. System (1) for increasing the energy efficiency of photovoltaic panels (2) according to any of the preceding claims, **characterized in that** in the system (1) each integrative panel (3) is geometrically perfectly congruent with a corresponding photovoltaic panel (2).

14. System (1) for increasing the energy performance of photovoltaic panels (2) according to any of the preceding claims, **characterized in that** said at least one photovoltaic panel (2) is, as such, high performance, and for example its photovoltaic cells are made of very high quality semiconductor material, i.e. ultra-pure monocrystalline silicon with a low rate of degradation over time; and **in that** it includes very low dispersion electrical contacts to draw the electric current generated by the silicon cells; and **in that** said photovoltaic cells are produced with highly solid mechanical characteristics capable of further reducing the degradation of the cells themselves over time.

15. Use of a system (1) for increasing the energy efficiency of photovoltaic panels (2) according to any of the preceding claims, in a photovoltaic plant or photovoltaic panel equipment (2), in order to increase the efficiency in energy supply, for example with the same surface area of the panels hit by solar rays.
